# EUROPEAN PATENT APPLICATION

(11) **EP 1 837 796 A1**
(43) Date of publication of application: **26.09.2007**
(21) Application number: 06300340.4
(22) Date of filing: 06.04.2006
(51) Int. Cl.: G06K 7/00, G06K 19/077

(54) **Connector for smart card**

(30) Priority: 23.03.2006 EP 06290513
(71) Applicant: Axalto SA, 92120 Montrouge (FR)
(72) Inventor: Reignoux, Yves, 92120 Montrouge (FR)
(74) Representative: Cour, Pierre

(57) **Abstract**

The invention aims to provide a connector for smart card comprising at least five contact pads, which are wire-bonded to chip terminals for receiving determined signals, said connector being specifically dedicated to one application, so that smart card can exchange data only with a specific adapted handset and vice versa. For that, the wiring of at least two contact pads is reversed.

## Description

The invention relates to a connector for smart card, a smart card including the connector, and also a reader of such smart card.

More particularly, the invention aims to offer a specific card which can only be used with a dedicated reader. Such offer can be used for mobile applications, for example mobile phone.

Smart cards can be for example a memory card or a microprocessor card. The invention applies to such microprocessor chip cards. Smart card is accessed with a card reader that has an aperture or a slot or else into which the smart card is inserted. The smart card reader covers every device used to receive or to be connected with a smart card and to dialog with it.

Some telephony operators propose to final users a handset which is dedicated to function with only one type of card, which is generally a prepaid card. The card may be, for example, either a 2G (2^{nd} generation) SIM (Subscriber Identity Module) card, or a 3G (3^{rd} generation) USIM card. However, the dedicated handset is not locked to function only with a single SIM card. At best, it is electronically locked to function only with the network of the telephony operator, but not to function on a specific application.

After having unlock the handset if necessary, fraudulent persons resell the handset and the card separately and make money on the operator subsidy.

Current solution to overcome this problem consists in gluing the SIM or USIM card into the handset. In this case, the card is bonded to the handset using an epoxy resin for example. This bonding step could be made by a third company.

Nevertheless, this solution is not optimum. The process stage is expensive and, if done by a third company, requires the management of a specific logistic chain. Moreover, this solution is not aesthetic and against normal SIM usage, which consists in letting the end-user insert the SIM card in the handset. Finally, there is still a risk of removing the SIM card without damage it.

In view of the above, a problem intended to be solved by the invention is to provide a connector for smart card comprising at least five contact pads, which are wire-bonded to chip terminals for receiving determined signals, said connector being specifically dedicated to one application, so that smart card can exchange data only with a specific adapted handset and vice versa.

The solution to this problem lies in the fact that the wiring of at least two contact pads is reversed.

Thus, the allocation of the contact pads is no more compliant with ISO standard, so that the connector of smart card can only function with another specific reader's connector adapted to communicate with it.

For a better understanding of the present invention, reference will now be made, by way of example, to the following description of the invention and to the accompanying drawings, in which:
- figure 1 is a schematic cross-sectional view of a current micro-electronic module adapted to be embedded in a smart card,
- figures 2A and 2B are schematic views of contact pads of a smart card connector and contact pins of a dedicated handset connector, respectively in a current ISO standard configuration and in a configuration according to the invention;
- figure 3A and 3B are schematic views of contact pads of a smart card connector and contact pins of a dedicated handset connector, respectively in a fraudulent configuration and in a configuration according to a further embodiment of the invention.

Corresponding numerals and symbols in the figures refer to corresponding parts, unless otherwise indicated.

In the following examples, the smart card is a USIM card, and the reader is an handset. However, these examples are given for illustration and should not be interpreted in a restrictive way. Namely, the invention applies to all type of smart card having a connector flushing its surface and all types of readers.

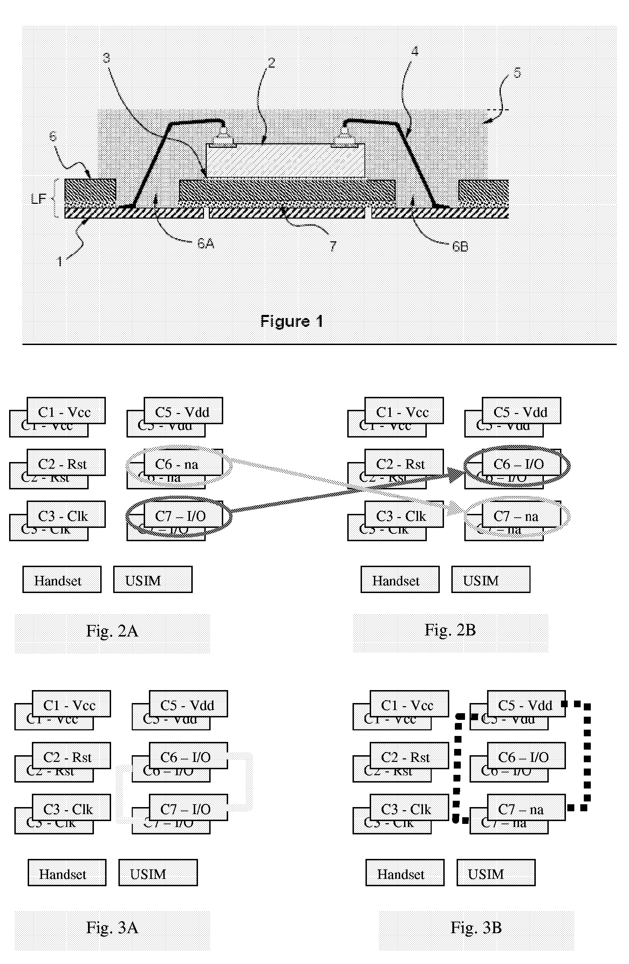

Current connectors of smart cards are designed according to ISO standard 7816. A current micro-electronic module adapted to be embedded in a smart card is schematized on figure 1. This module comprises a leadframe LF, a chip 2, connection wires 4 and an encapsulation 5. The leadframe LF comprises a metal grid 1 and a support layer 6 (e.g. made of a dielectric material). The support layer 6 comprises a certain number of holes 6A, 6B for connection purpose. The support layer is coupled to the metal grid by means of a first glue layer 7. The chip is coupled to the leadframe LF by a second glue layer 3 (e.g. an epoxy glue). The connections wires 4 (e.g. gold, aluminum or copper wires) connect contact terminals of the chip 2 to particular portions of the metal grid 1 via the holes 6A, 6B. These particular portions of the metal grid 1 constitute contact pads for connecting the micro-electronic module to an external reader (not shown). The encapsulation 5 (e.g. an epoxy thermal or UV resins) protects the chip 2 and the connections wires 4.

In figure 2A, are represented respectively contact pads of a smart card connector and contact pins of a reader connector.

Contact pads define the smart card connector. This connector is currently compliant with ISO standard 7816 and comprises either 6 or 8 useful electrical contact pads. Contact pads are named C1 to C8 in ISO standard 7816-2. Moreover, the standard envisages the allocation of contact pads to particular signals. Thus, in the configuration of 6 contact pads of microprocessor chip cards as illustrated on figure 2A, contact pad C1 is provided for receiving a supply voltage Vcc, C2 supports the initialization signal Rst, C3 corresponds to a clock signal Clk, C5 receives a ground signal and C7 corresponds to an Input/output I/O signal. The allocation of the C6 contact pad to a particular signal is not standardized, only its position and, in microprocessor chip cards, this particular contact pad is not used, so that it is not wired.

In order to propose a smart card that can exchange data with only one dedicated reader and vice versa, the wiring of the contact pads of the connector is modified, so that the allocation of at least two contact pads is reversed, as illustrated on figure 2B. In this case, the specific connector is no more compliant with ISO standard, and is therefore dedicated to only one application.

In the example of figure 2B, the currently not connected C6 contact pad is used for being wired and connected to a contact terminal of the chip, so that it receives a signal, which is generally allocated to another contact pad. In this example, the I/O signal, which is currently allocated to C7 contact pad, has been allocated to the C6 contact pad which is currently not connected. This is just an example, and the wiring between two unspecified contact pads can be reversed. The fact to allocate the currently "not used" C6 contact pad to any other signal allows to simplify the industrialisation of the configuration. In this particular example, C7 contact pad becomes the "not used" contact pad.

For the telephony operator this modification of the wiring of the contact pads allows him to use his current supply chain, without requiring the involvement of a potential third company, and to propose an elegant dedicated handset/SIM card configuration to the end-user.

For the card manufacturer, this modification is easy to implement because the wire-bonding affectation can be adjusted case by case by software, as long as allocation does not oblige to cross wires.

If the modification of the wiring between two contact pads, for example between C6 and C3, would force to cross wires, the realisation of the connector is a little bit more complex to implement. Indeed, for avoiding a crossing of the wires, this wiring requires to use a double-side leadframe to make a stripe for wiring the C6 contact pad, so that it receives the clock signal from the chip. If chip and leadframe lay out let it technically possible, it is also possible to do it only by direct wiring with specific loop mode or shape.

For the handset manufacturer, connector is generally manufactured with 6 pins. So, the best way to modify the wiring of its connector is to adapt the printed circuit board. In the preceding example, the adaptation of the printed circuit board consists in connecting C6 pin and in cutting C7 pin wiring.

This embodiment presents the advantage to be cheap and elegant.

However, if the inversion of the wiring of two contact pads leads to a change of the "not used" contact pad as it is described in the preceding example, it could still be possible for hackers to modify the connector to come back to an ISO pad affectation. Indeed, such a modification would consist in bonding the reversed contact pads by making a stripe. In the example of figure 3A, this modification consists in bonding C6 contact pad and C7 contact pad, so that C7 contact pad receives again the I/O signal. In this case, the stripe on USIM connector between C6 and C7 can be made with a conductive silver glue for example. This stripe is visible and easy to detect. On the other hand, the stripe on handset connector between C6 and C7 pins can be made by welding a wire on the connector pin just before the printed board circuit.

To overcome such possible fraud, an improved embodiment consists in creating a short -circuit between the newly "not used" contact pad C7 and another wired contact pad. Namely, the contact pad, which is anymore connected to chip terminal, i.e C7 in the examples of figures 2B to 3B, can be also electrically bonded to another contact pad that receives a signal, such as C5, which receives a ground signal, as illustrated in the example of figure 3B, so as to create a short-cut.

For the USIM module, the C5 short-cut on C7 is made thanks to a wire between leadframe C5 and C7 bonding holes 6A, 6B. In this case, the short-circuit becomes impossible to remove without breaking the module.

For the handset, the stripe between C5 and C7 is made via the printed circuit board. In this case, a potential hacker can not modify the printed circuit board without breaking the handset shell.

Electrically, the short-circuit would be more efficient by connecting the modified "not used" contact pad C7 to a contact pad that receives an active signal instead of the ground. C7 can for example be connected to C3 contact pad intended to receive clock signal. In this latter case, the wiring is a little bit more complex to implement because it involves the use of a double side leadframe for avoiding a wire crossing. If chip and leadframe lay out let it technically possible, it is also possible to do it only by direct wiring with specific loop mode or shape.

## Claims

1. Connector for smart card comprising at least five (C1-C5, C7) contact pads, which are wire-bonded to chip terminals for receiving determined signals, wherein the wiring of at least two contact pads is reversed.

2. Connector as claimed in claim 1, said connector comprising a sixth contact pad (C6) which is not connected, wherein the inversion of the wiring between two contact pads consists in wire-bonding the sixth contact pad (C6) to a chip terminal, so that another contact pad (C7) becomes not connected.

3. Connector as claimed in claim 2, wherein the newly not-connected contact pad (C7) is bonded to another wired contact pad so as to create a short-circuit between the two contact pads.

4. Smart card comprising a card body provided with a cavity in which is positioned an electronic module, said electronic module comprising at least a chip whose contact terminals are electrically connected to contact pads of a connector flushing the surface of the card, wherein the connector is in conformity with one of the preceding claims 1 to 3.

5. S mart card as claimed in claim 4, wherein the card is a SIM card.

6. Reader adapted for communicating with a smart card of claim 4 or 5, comprising contact pins adapted to be electrically connected with contact pads of the connector of one of the claims 1 to 3, for the establishment of the communication.
